(19) Europäisches Patentamt
European Patent Office
Office européen des brevets

(11) **EP 4 131 418 A1**

(12) **EUROPEAN PATENT APPLICATION**
published in accordance with Art. 153(4) EPC

(43) Date of publication:
**08.02.2023 Bulletin 2023/06**

(51) International Patent Classification (IPC):
**H01L 29/06** $^{(1974.07)}$         **H01L 29/36** $^{(1974.07)}$

(21) Application number: **20927940.5**

(52) Cooperative Patent Classification (CPC):
**H01L 29/06; H01L 29/36; H01L 29/739; H01L 29/74**

(22) Date of filing: **27.10.2020**

(86) International application number:
**PCT/CN2020/123817**

(87) International publication number:
**WO 2021/189838 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.03.2020 CN 202010215412**

(71) Applicant: **Tsinghua University**
**Haidian District**
**Beijing 100084 (CN)**

(72) Inventors:
• **ZENG, Rong**
**Beijing 100084 (CN)**
• **LIU, Jiapeng**
**Beijing 100084 (CN)**
• **ZHAO, Biao**
**Beijing 100084 (CN)**
• **CHEN, Zhengyu**
**Beijing 100084 (CN)**
• **YU, Zhanqing**
**Beijing 100084 (CN)**
• **ZHOU, Wenpeng**
**Beijing 100084 (CN)**
• **ZHANG, Xiangyu**
**Beijing 100084 (CN)**

(74) Representative: **Huang, Liwei**
**Cäcilienstraße 12**
**40597 Düsseldorf (DE)**

(54) **BUFFER REGION VARIABLE DOPING STRUCTURE USED FOR OVERVOLTAGE BREAKDOWN FUNCTION, AND SEMICONDUCTOR DEVICE**

(57)    The present invention relates to the field of semiconductor devices, and discloses a buffer-region variable doping structure for an overvoltage breakdown function and a semiconductor device. The buffer-region variable doping structure is disposed in a semiconductor device, where when the semiconductor device withstands a breakdown voltage, the buffer-region variable doping structure withstands an electric field generated by the semiconductor device, such that the electric field punches through the buffer-region variable doping structure. In the present invention, the overvoltage controllable breakdown is performed according to a local punch-through principle, and the present invention has the advantages of stable temperature, an easily implemented process, a consistent breakdown voltage, and a controllable punch-through point.

FIG. 4

**Description**

**CROSS-REFERENCE TO RELATED APPLICATIONS**

The present application claims the priority to Chinese Patent Application No. 202010215412.2, titled "BUFFER-REGION VARIABLE DOPING STRUCTURE FOR OVERVOLTAGE BREAKDOWN FUNCTION AND SEMICONDUCTOR DEVICE", and filed with China National Intellectual Property Administration (CNIPA) on March 24, 2020, Chinese Patent Application No. 202020388279.6, titled "BUFFER-REGION VARIABLE DOPING STRUCTURE FOR OVERVOLTAGE BREAKDOWN FUNCTION AND SEMICONDUCTOR DEVICE", and filed with China National Intellectual Property Administration (CNIPA) on March 24, 2020, which are incorporated herein by reference in entireties thereof.

**FIELD OF TECHNOLOGY**

The present invention relates to the field of semiconductor devices, and in particular to a buffer-region variable doping structure for an overvoltage breakdown function and a semiconductor device.

**BACKGROUND**

An IGCT device is a new-generation current-controlled device developed on the basis of GTO. A GCT chip is made through the transparent anode technology and designed with buffer layers, which reduces the trigger current level and on-voltage drop of the device. In the aspect of gate drive circuit together with the turn-on and turn-off mechanisms, the IGCT adopts the integrated drive circuit, optimizes the circuit layout and the structure of housing package, and reduces the parasitic parameters of commutation loop to the level of nanohenry, so that the device can commutate all current from cathode electrode to gate electrode in a short period in the turn-off process, and then the PNP transistor can be turned off naturally.

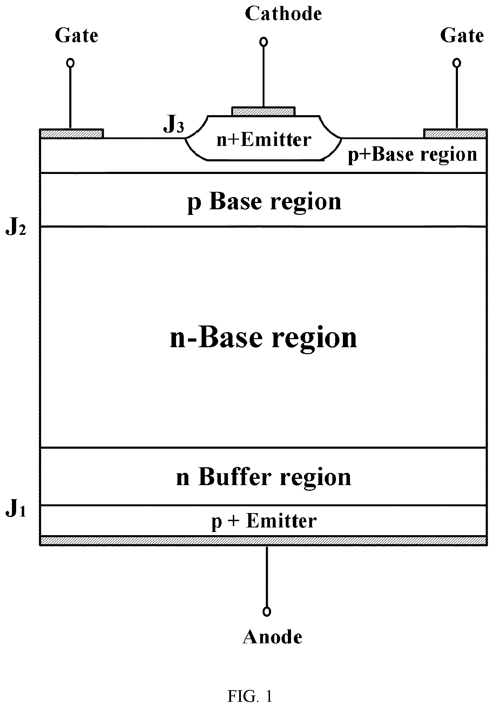

With reference to FIG. 1, FIG. 1 is a schematic diagram of an existing GCT chip structure. For the existing GCT chip, when statically blocking or dynamically turning off, the J2 junction withstands the voltage above the kV level between a cathode and an anode. It should be noted that to ensure the high-voltage withstand capability, the n-type drift region is usually made into a low-doped concentration region from the original silicon single crystal. In this case, the voltage mainly drops in the n-type drift region. In addition, according to the Poisson equation, the change rate of the electric field is proportional to the doping concentration, that is, a lower doping concentration offers a higher blocking voltage with properly designed structure.

Semiconductor devices show unique advantages in the fields of large-capacity flexible power transmission due to their high blocking voltage capabilities, high controllable current levels, low conduction loss, high reliability, and low costs. Existing semiconductor devices include IGBT, IEGT, IGCT, ETO MCT, and the like.

In recent years, in applications such as modular multilevel converter, it is expected that semiconductor devices are broken down stably or protected stably after reaching a specific voltage value. In this way, other devices such as capacitors and diodes in the module are protected from breakdown due to overvoltage, or the module can be reliably bypassed to ensure that the system can still operate normally, and the reliability of system operation is improved. Because the use of external circuits for breakdown or protection may raise electromagnetic interference and power loss problems, the overvoltage breakdown or protection scheme based on chip-level structure optimization exhibits better application potentials.

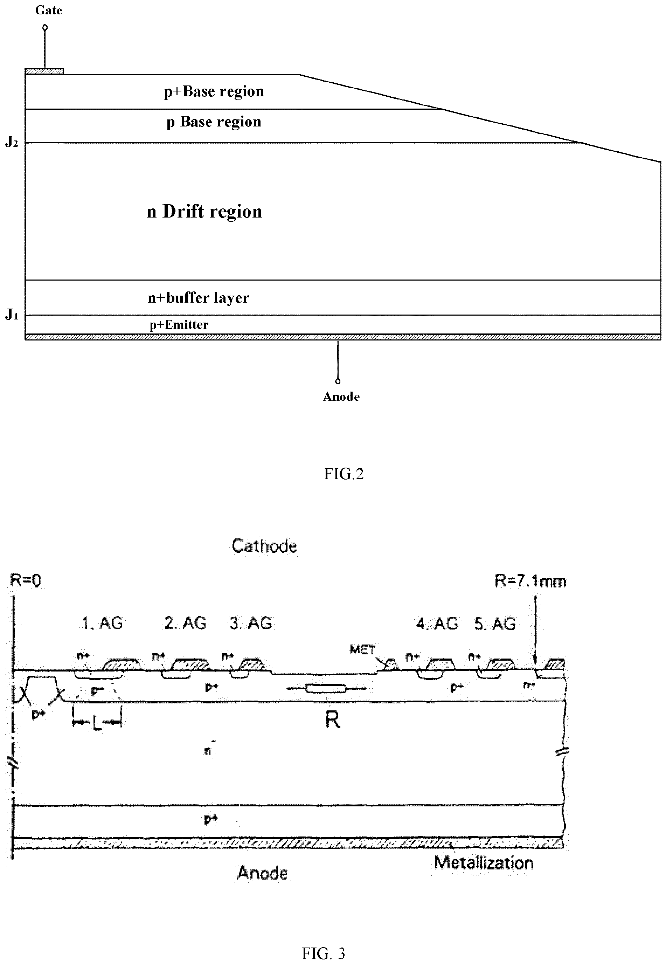

Taking the GCT as an example, with reference to FIG. 1, FIG. 1 is a cross-sectional schematic diagram of a conventional silicon-based GCT unit. As shown in FIG, 1, in the conventional GCT or thyristor devices, the forward withstand voltage is mainly borne by the J2 junction marked in the figure. To ensure the stable breakdown voltage performance of the device under a high voltage, it is usually necessary to grind and passivate the edge. With reference to FIG. 2, FIG. 2 is a schematic diagram of conventional GCT edge grinding. In the practical application, the direct use of traditional structures for overvoltage breakdown mainly faces two problems: limited by factors such as process stability and contamination, the breakdown voltage and leakage current levels of the devices after the edge passivation treatment usually have a dispersion, and are difficult to test and screen; and If the overvoltage breakdown occurs and the system energy is large, because the weak point of voltage withstanding is at the edge, the influx of inrush current is likely to cause the rupture of the device shell structure, threatening the safe operation of the entire valve. Therefore, as for the IGCT, IGBT, SGTO, and the like, the weak points of their breakdown voltages are all at the edge. In addition, the edge of the IGCT is handled by grinding the corner, and the edges of the IGBT and other devices are handled through technologies such as junction terminal expansion. However, the two edge handling manners cause unstable and uncontrollable problems.

In addition, with reference to FIG. 3, FIG. 3 is a schematic structural diagram of a thyristor BOD. In the conventional thyristor structure, to solve this problem, the BOD (break over diode) structure shown in FIG. 3 is usually configured to protect the overvoltage. When an overvoltage condition occurs, the BOD structure first generates a relatively strong leakage current, and the lateral voltage raised by the leakage current triggers the electron emission at the amplifying gate, thereby conducting the thyristor device and avoiding failure.

The essence of the BOD structure is to create a weak point for avalanche breakdown in the device body (usually at the center), thereby ensuring that the device at the BOD structure is broken down stably under a specific voltage. However, because the avalanche coefficient is greatly affected by a temperature, there may be about 10% or higher variation in the protection threshold value at different temperatures with an identical doping structure. However, when this technology is applied to a semiconductor device, it is difficult to use the BOD structure to reliably protect the overvoltage of the device due to the limitations of the device structure and process implementation.

Therefore, it is urgently necessary to develop a buffer-region variable doping structure and a semiconductor device having the same to overcome the foregoing defects.

## SUMMARY

To resolve the foregoing problem, the present invention provides a buffer-region variable doping structure for an overvoltage breakdown function. The buffer-region variable doping structure is disposed in a semiconductor device, where when the semiconductor device withstands a breakdown voltage, the buffer-region variable doping structure withstands an electric field generated by the semiconductor device, such that the electric field punches through the buffer-region variable doping structure.

The buffer-region variable doping structure includes a first dopant region A and a second dopant region B, where the first dopant region A and the second dopant region B are attached up and down, and when the semiconductor device withstands the breakdown voltage, the first dopant region A and the second dopant region B generate the electric field.

The buffer-region variable doping structure further includes a second dopant region C and a second dopant region D, where the second dopant region C is connected to the second dopant region D, the second dopant region C and the second dopant region D are in a same layer and are both attached to the second dopant region B up and down, and a total dopant dose of the second dopant region D is smaller than a total dopant dose of the second dopant region C, when the second dopant region C and the second dopant region D withstand the electric field, such that the electric field punches through the second dopant region D.

The buffer-region variable doping structure further includes a second dopant region C, a second dopant region D, and a first dopant region E, where the second dopant region C and the first dopant region E are connected to the second dopant region D, the second dopant region C and the second dopant region D are attached to the second dopant region B up and down, the first dopant region E and the second dopant region C are attached up and down, and a total dopant dose of the second dopant region D is smaller than a total dopant dose of the second dopant region C, when the second dopant region C and the second dopant region D withstand the electric field, such that the electric field punches through the second dopant region D.

The buffer-region variable doping structure further includes a second dopant region C, a second dopant region D, a first dopant region E, and a first dopant region F, where the second dopant region C is connected to the second dopant region D, the first dopant region E is connected to the first dopant region F, the second dopant region C and the second dopant region D are attached to the second dopant region B up and down, the first dopant region E and the second dopant region C are attached up and down, the first dopant region F and the second dopant region D are attached up and down, and a total dopant dose of the second dopant region D is smaller than a total dopant dose of the second dopant region C, when the second dopant region C and the second dopant region D withstand the electric field, such that the electric field punches through the second dopant region D.

According to the buffer-region variable doping structure, the total dopant dose of the second dopant region D is obtained according to the following formula:

$$Q_1 = \frac{\varepsilon_{Si} \times E_1}{q}$$

where $Q_1$ is a net total quantity of the dopant per unit area of the second dopant region D, $\varepsilon_{Si}$ is a dielectric coefficient of a base material, $E_1$ is an electric field strength at an interface between the second dopant region D and the second dopant region B under the designed breakdown voltage, and q is a unit charge.

In the buffer-region variable doping structure, a net total quantity of the dopant per unit area of the first dopant region F is smaller than each of the net total quantities of the dopants per unit area of the other dopant regions.

In the buffer-region variable doping structure, the net total quantity of the dopant per unit area of the first dopant region F makes the buffer-region variable doping structure under static blocking have a hole emission efficiency equal to or lower than that of another dopant region.

The present invention provides a semiconductor device, including the buffer-region variable doping structure described above, where when the semiconductor device withstands a breakdown voltage, the buffer-region variable doping structure withstands an electric field generated by the semiconductor device, such that the electric field punches through the buffer-region variable doping structure.

The semiconductor device is one of IGCT, GTO, SGTO, IGBT, IEGT, MCT, and ETO.

Compared with the related art, the present invention has the following effects: Overvoltage self-destruction is performed on the buffer-region variable doping structure and a semiconductor device having the same in the present invention according to the local punch-through principle, with the advantages of good temperature stability, easy process realization, and good voltage consistency. Further, because the punch-through point is located in the body, after the self-destruction, the device can usually be remained in a reliable short-circuit state for a long time.

Other features and advantages of the present invention are described in the specification, and some of them are apparent from the description, or may be learned by practice of the present invention. The objectives and other advantages of the present invention may be implemented and obtained by using the structure described in the specification, claims, and drawings.

## BRIEF DESCRIPTION OF THE DRAWINGS

In order to more clearly describe technical solutions in the embodiments of the present disclosure or in the prior art, a brief introduction to the accompanying drawings required for the description of the embodiments or the prior art is provided below. Obviously, the accompanying drawings described below are merely some embodiments of the present disclosure. Those of ordinary skill in the art can derive other accompanying drawings from these accompanying drawings without making inventive efforts.

FIG. 1 is a cross-sectional schematic diagram of a conventional silicon-based GCT unit.
FIG. 2 is a schematic diagram of conventional GCT edge grinding.
FIG. 3 is a schematic structural diagram of a thyristor BOD.
FIG. 4 is a schematic diagram of a buffer-region variable doping structure according to a first embodiment of the present invention.
FIG. 5 is a schematic distribution diagram of electric fields in various places of the buffer-region variable doping structure in FIG. 4 under a state of withstanding a designed breakdown voltage.
FIG. 6 is a schematic diagram of the buffer-region variable doping structure according to a second embodiment of the present invention.
FIG. 7 is a schematic diagram of a buffer-region variable doping structure according to a third embodiment of the present invention.
FIG. 8 is a schematic structural diagram of IGCT according to the present invention.
FIG. 9 is a schematic distribution diagram of electric fields in various places of IGCT in FIG. 8 under a state of withstanding a designed breakdown voltage.
FIG. 10 shows that the buffer-region variable doping structure is arranged in a center of a GCT chip.
FIG. 11 shows that the buffer-region variable doping structure is arranged at a junction of the GCT and a diode.

FIG. 12 is a schematic structural diagram of an n-type planar IGBT according to the present invention.
FIG. 13 is a schematic distribution diagram of electric fields in various places of IGBT in FIG. 12 under a state of withstanding a designed breakdown voltage.
FIG. 14 is a schematic structural diagram of n-type MCT according to the present invention.
FIG. 15 is a schematic distribution diagram of electric fields in various places of MCT in FIG. 14 under a state of withstanding a designed breakdown voltage.

## DESCRIPTION OF THE EMBODIMENTS

In order to make the objectives, technical solutions and advantages of the embodiments of the present invention clearer, the technical solutions in the embodiments of the present invention are clearly and completely described below in conjunction with the drawings in the embodiments of the present invention. Apparently, the described embodiments are some rather than all of the embodiments of the present invention. All other embodiments obtained by those of ordinary skill in the related art on the basis of the embodiments of the present invention without creative efforts shall fall within the protection scope of the present invention.

Directional terms used herein, such as: up, down, left, right, front or back, only refer to the orientations of the drawings. Therefore, the directional terms used are intended to be illustrative and not intended to limit the present invention.

As used herein, "comprise", "include", "have", "contain", and the like, are open-ended terms and mean including but not limited to.

The exemplary embodiments of the present invention and the descriptions thereof are used to explain the present invention rather than limiting the present invention. In addition, elements/members with the same or similar reference numerals used in the drawings and the embodiments are intended to represent the same or similar parts.

The buffer-region variable doping structure for an overvoltage breakdown function in the present invention is disposed in a semiconductor device. When the semiconductor device withstands a breakdown voltage, the buffer-region variable doping structure withstands an electric field generated by the semiconductor device, such that the electric field punches through the buffer-region variable doping structure.

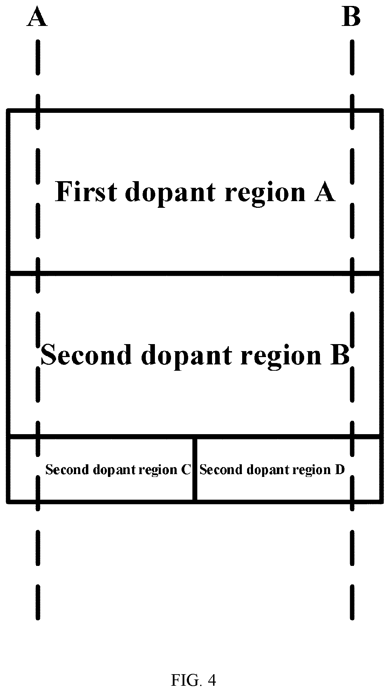

With reference to FIG. 4, FIG. 4 is a schematic diagram of a buffer-region variable doping structure according to a first embodiment of the present invention. As shown in FIG. 4, the buffer-region variable doping structure for an overvoltage breakdown function of the present invention includes a first dopant region A and a second dopant region B, the first dopant region A and the second dopant region B are attached up and down, and when the semiconductor device withstands the breakdown voltage, the first dopant region A and the second dopant region B generate the electric field.

In this embodiment, the first dopant region A and the second dopant region B are each a p-type dopant or an n-type dopant. Specifically, if the first dopant region A is the p-type dopant, the second dopant region B is the n-type dopant, and vice versa.

Further, the buffer-region variable doping structure further includes a second dopant region C and a second dopant region D, where the second dopant region C is connected to the second dopant region D, the second dopant region C and the second dopant region D are in a same layer and are both attached to the second dopant region B up and down, and when the second dopant region C and the second dopant region D withstand the electric field, a total dopant dose of the second dopant region D is smaller than a total dopant dose of the second dopant region C, such that the electric field punches through the second dopant region D.

Specifically, to improve the overall performance of the device, the buffer-region variable doping structure of the present invention includes a second dopant region C and a second dopant region D. According to the principle of semiconductor physics, when the semiconductor device withstands the breakdown voltage, the second dopant region C and the second dopant region D both withstand the electric field generated by the semiconductor device. The total dopant dose of the second dopant region D is smaller than that of the second dopant region C. Therefore, the electric field does not punch through the second dopant region C, but the second dopant region D.

Further, the total dopant dose of the second dopant region D is obtained according to the following formula:

$$Q_1 = \frac{\varepsilon_{Si} \times E_1}{q}$$

where $Q_1$ is a net total quantity of the dopant per unit area of the second dopant region D, $\varepsilon_{Si}$ is a dielectric coefficient of a base material, $E_1$ is an electric field strength at an interface between the second dopant region D and the second dopant region B under the designed breakdown voltage, and q is a unit charge.

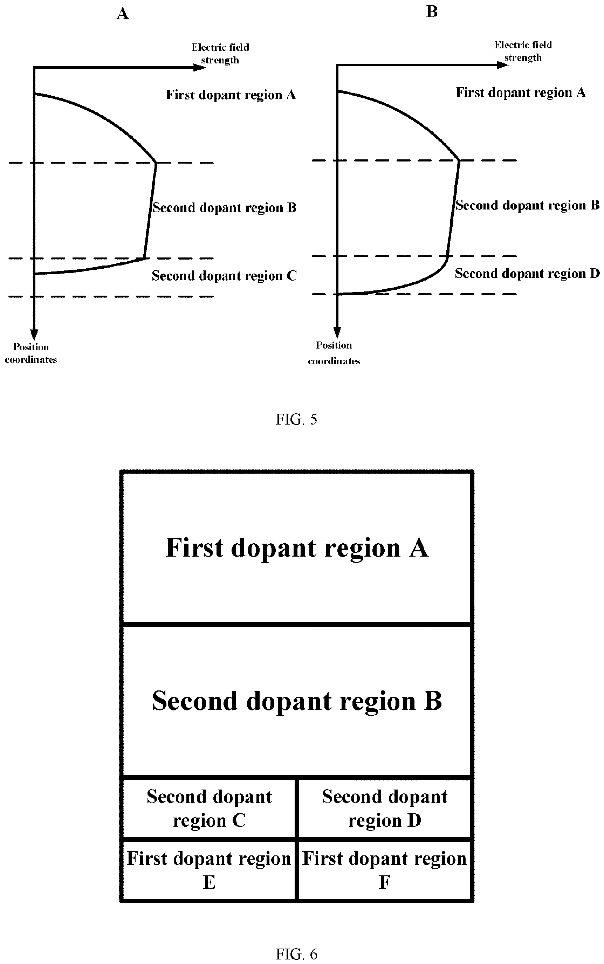

Specifically, with reference to FIG. 5, FIG. 5 is a schematic distribution diagram of electric fields in various places of the buffer-region variable doping structure in FIG. 4 under a state of withstanding a designed breakdown voltage. As shown in FIG. 5, the doping of the second dopant region D needs to ensure that when the semiconductor device statically withstands the designed breakdown voltage value, the electric field applied between the first dopant region A and the second dopant region B punches through the second dopant region D exactly. The electric field distribution under the critical state is shown in FIG. 5. The total dopant dose of the second dopant region D may be designed with reference to the foregoing formula. Therefore, the design of the second dopant region D can not only reduce the doping concentration while ensuring the junction depth, but also reduce the junction depth and the doping concentration at the same time.

With reference to FIG. 6, FIG. 6 is a schematic diagram of a buffer-region variable doping structure according to a second embodiment of the present invention. The buffer-region variable doping structure in FIG. 6 and the one in FIG. 4 are roughly the same. Therefore, only the different parts are described below. In this embodiment, the buffer-region variable doping structure further includes a second dopant region C, a second dopant region D, a first dopant region E, and a first dopant region F, where the second dopant region C is connected to the second dopant region D, the first dopant region E is connected to the first dopant region F, the second dopant region C and the second dopant region D are attached to the second dopant region B up and down, the first dopant region E and the second dopant region C are attached up and down, the first dopant region F and the second dopant region D are attached up and down, and when the second dopant region C and the second dopant region D withstand the electric field, a total dopant dose of the second dopant region D is smaller than a total dopant dose of the second dopant region C, such that the electric field punches through the second dopant region D.

In this embodiment, the net total quantity of the dopant per unit area of the first dopant region F makes the buffer-region variable doping structure under static blocking have a hole emission efficiency equal to or lower than that of another dopant region.

Generally, in most of the semiconductor devices, below the region C exists a first dopant region E for carrier emission, including a first dopant of a higher concentration. When the buffer-region variable doping structure of the present invention is applied to such a structure, generally, a first dopant region F with a small-dose dopant is disposed under the second dopant region D. To reduce the leakage current level, the first dopant region F may be lower than the remaining regions. Specifically, the first dopant region F may be not doped with the first dopant.

In an embodiment of the present invention, a net total quantity of the dopant per unit area of the first dopant region F is smaller than each of the net total quantities of the dopants per unit area of the other dopant regions.

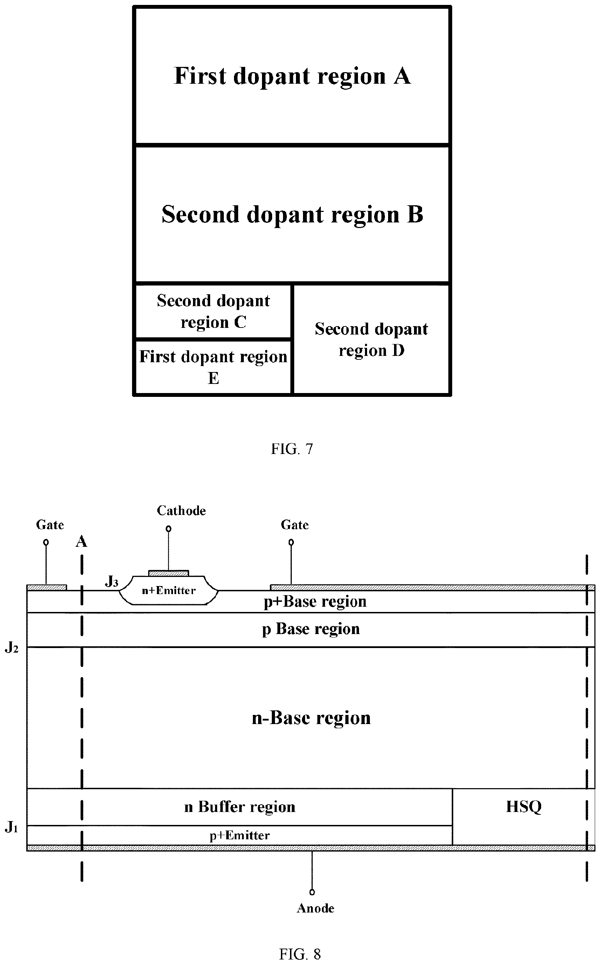

With reference to FIG. 7, FIG. 7 is a schematic diagram of a buffer-region variable doping structure according to a third embodiment of the present invention. The buffer-region variable doping structure in FIG. 7 and the one in FIG. 6 are roughly the same. Therefore, only the different parts are described below. In this embodiment, the buffer-region variable doping structure further includes a second dopant region C, a second dopant region D, and a first dopant region E, where the second dopant region C and the first dopant region E are connected to the second dopant region D, the second dopant region C and the second dopant region D are attached to the second dopant region B up and down, the first dopant region E and the second dopant region C are attached up and down, and when the second dopant region C and the second dopant region D withstand the electric field, a total dopant dose of the second dopant region D is smaller than a total dopant dose of the second dopant region C, , such that the electric field punches through the second dopant region D.

The present invention further provides a semiconductor device, including the buffer-region variable doping structure HSQ described above, where when the semiconductor device withstands a breakdown voltage, the buffer-region variable doping structure HSQ withstands an electric field generated by the semiconductor device, such that the electric field punches through the buffer-region variable doping structure HSQ.

The semiconductor device is one of IGCT, GTO, SGTO, IGBT, IEGT, MCT, and ETO.

Embodiment 1: IGCT (GTO, SGTO, and ETO) types.

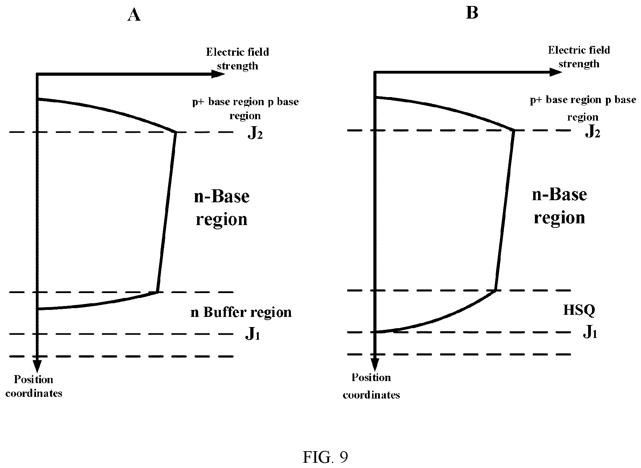

For the IGCT-type device, thousands of small cells are usually connected in parallel on one chip. With reference to FIG. 8, FIG. 8 is a schematic structural diagram of IGCT according to the present invention. FIG. 9 is a schematic distribution diagram of electric fields in various places of IGCT in FIG. 8 under a state of withstanding a designed breakdown voltage. As shown in FIGS. 8 and 9, the silicon-based GCT chip integrated with the buffer-region variable doping structure for an overvoltage breakdown function has the following typical features:

a, The doping of the second dopant region D needs to ensure that when the chip statically withstands the designed breakdown voltage value, the electric field of the J2 junction punches through the second dopant region D exactly. The electric field distribution under the critical state is shown in FIG. 9. The total dopant dose of the second dopant region D may be designed according to the foregoing formula. Specifically, the design of the second dopant region D can either reduce the doping concentration while maintaining the junction depth, or reduce the junction depth and the doping concentration at the same time.

b, To reduce the leakage current level, the concentration of the first dopant region F may be lower than those of the other regions. Preferably, the concentration of the first dopant region F should be selected to make this region under static blocking have a hole emission efficiency equal to or lower than that of another dopant region.

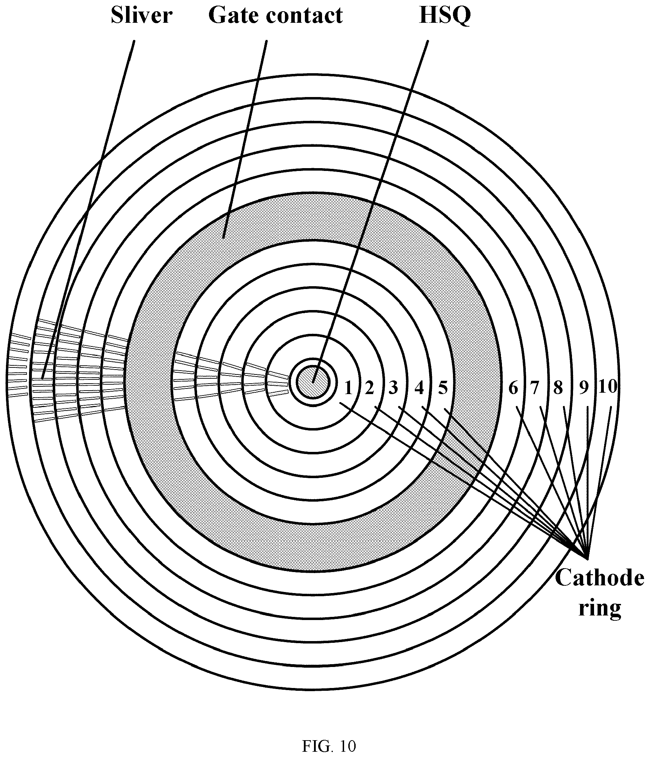

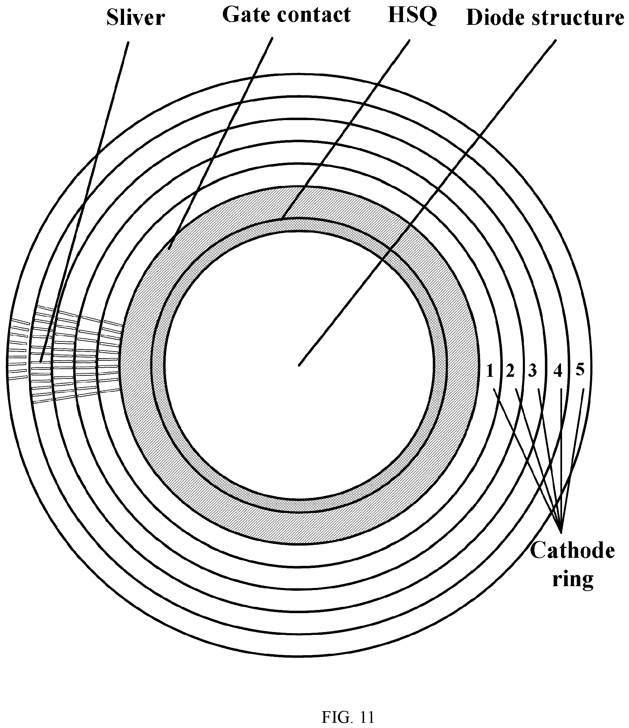

c, The second dopant region D may in principle be arranged at any position other than the boundary. However, to reasonably use device area, the structure is usually arranged in the center of a GCT chip in case of an asymmetric IGCT,. As shown in FIG. 10, the buffer-region variable doping structure is arranged in the center of the GCT chip. For the reverse-conduction-type GCT chip in which the diode and the GCT are separated, the structure is usually arranged at the junction of the GCT and the diode. As shown in FIG. 11, FIG. 11 shows that the buffer-region variable doping structure is arranged at a junction of the GCT and the diode.

d, A lateral distance between at least one point in the second dopant region D and the boundary of the region is greater than the thicknesses of the region C and region D. Taking the circle arranged in the center as an example, the radius of the low-dose buffer circular region should be larger than the thicknesses of the region C and region D.

e, It should be noted that it is not necessary that the second dopant region D corresponds to the gate metal contact on the cathode side. However, to ensure the consistency of the breakdown point, it is recommended to configure the corresponding gate metal contact and connect it to the other parts of the gate contact.

The buffer-region variable doping structure of the present invention is not only suitable for ETO, GTO and SGTO devices with the same material and different structures, but also for ETO, GCT, GTO and SGTO devices with different materials. Devices with different materials have different dopants.

Embodiment 2: the IGBT (IEGT) type.

Because the basic structures of IEGT and IGBT are the same, the plasma-enhanced performance is realized in IGBT through special structure or design method, and it is collectively referred to as IGBT in this part. For the IGBT-type device, thousands of small cells are usually connected in parallel on one chip. The IGBT-type structures according to the channel type can be classified into: the planar-type IGBT, the trench-type IGBT, and the like. According to the type of drift region dopants, the IGBT-type structures can be classified into the n-type IGBT and the p-type IGBT. Description is made by using the n-type planar IGBT as an example.

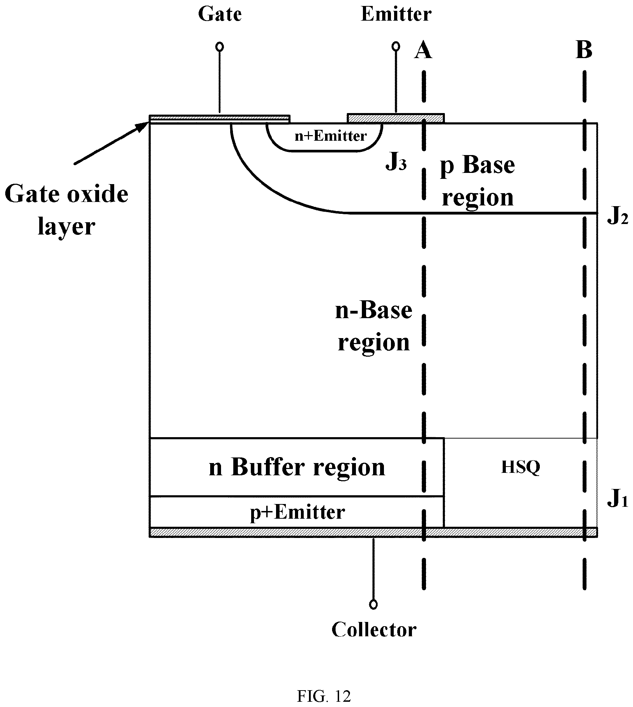

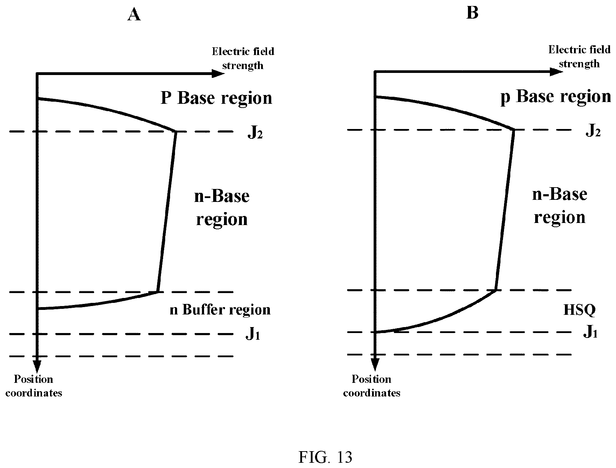

With reference to FIG. 12, FIG. 12 is a schematic structural diagram of an n-type planar IGBT according to the present invention. FIG. 13 is a schematic distribution diagram of electric fields in various places of IGBT in FIG. 12 under a state of withstanding a designed breakdown voltage. As shown in FIGS. 12 and 13, the n-type planar IGBT chip integrated with the buffer-region variable doping structure for an overvoltage breakdown function has the following typical features:

a, The doping of the second dopant region D needs to ensure that when the chip statically withstands the designed breakdown voltage value, the electric field of the J2 junction punches through the second dopant region D exactly. The electric field distribution under the critical state is shown in FIG. 13. The total dopant dose of the second dopant region D may be designed according to the foregoing formula. Specifically, the design of the second dopant region D can not only reduce the doping concentration while ensuring the junction depth, but also reduce the junction depth and the doping concentration at the same time.

b, To reduce the leakage current level, the concentration of the first dopant region F corresponding to the second dopant region D may be lower than those of the other regions. Preferably, the concentration of the first dopant region F should be selected to make this region under static blocking have a hole emission efficiency equal to or lower than that of another dopant region.

Because the design principle of p-type IGBT-type devices is the same as that of n-type devices, only dopants selected are different. This is not described herein again.

Because the design principle of the IEGT-type chip with the buffer-region variable doping structure for the overvoltage breakdown function is the same as that of the IGBT. This is not described herein again.

Embodiment 3: the MCT type.

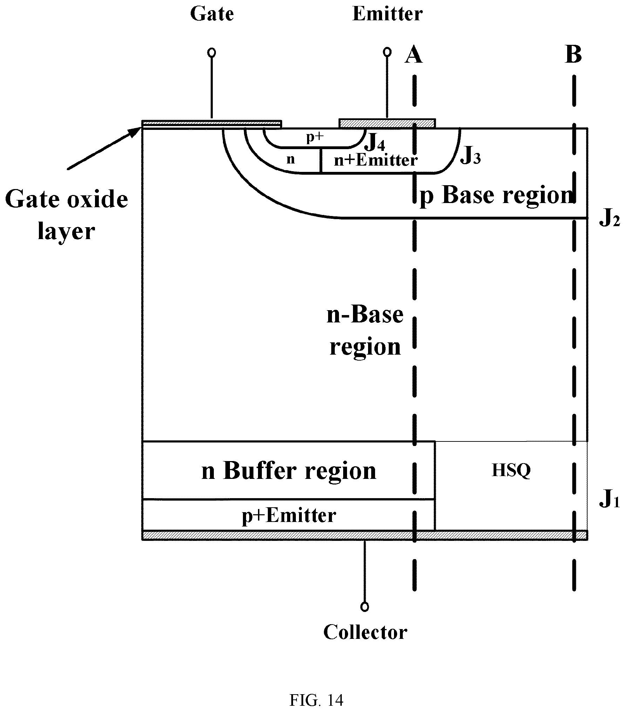

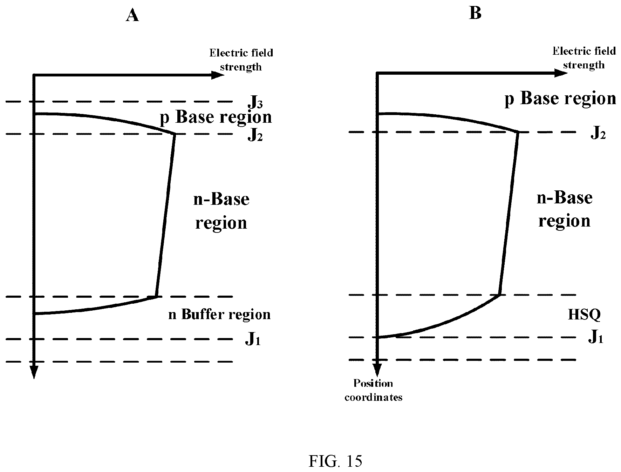

For the MCT-type device, thousands of small cells are usually connected in parallel on one chip. With reference to FIG. 14, FIG. 14 is a schematic structural diagram of n-type MCT according to the present invention. FIG. 15 is a schematic distribution diagram of electric fields in various places of MCT in FIG. 14 under a state of withstanding a designed breakdown voltage. As shown in FIGS. 14 and 15, the MCT chip integrated with the buffer-region variable doping structure for an overvoltage breakdown function has the following typical features:

a, The doping of the second dopant region D needs to ensure that when the chip statically withstands the designed breakdown voltage value, the electric field of the J2 junction punches through the second dopant region D exactly. The electric field distribution under the critical state is shown in FIG. 13. The total dopant dose of the second dopant region D may be designed according to the foregoing formula. Specifically, the design of the second dopant region D can not only reduce the doping concentration while ensuring the junction depth, but also reduce the junction depth and the doping concentration at the same time.

b, To reduce the leakage current level, the concentration of the first dopant region F corresponding to the second dopant region D may be lower than those of the other regions. Preferably, the concentration of the first dopant region F should be selected to make this region under static blocking have a hole emission efficiency equal to or lower than that of another dopant region.

Because the design principle of p-type MCT-type devices is the same as that of n-type devices, only dopants selected are different. This is not described herein again.

In summary, in the present invention, the overvoltage breakdown is performed according to the local punch-through principle, and the present invention has the advantages of stable temperature, an easily implemented process, a consistent breakdown voltage, and a controllable punch-through point.

Although the present invention has been described in detail with respect to the previously described embodiments, it should be understood by those of ordinary skill in the related art, the technical solutions recorded in the embodiments may be still modified, or part of its technical features may be replaced with equivalents; and such modifications or substitutions do not deviate the nature of the technical solutions from the spirit and scope of the technical solutions of the various embodiments in the utility model.

**Claims**

1. A buffer-region variable doping structure for an overvoltage breakdown function, disposed in a semiconductor device, wherein when the semiconductor device withstands a breakdown voltage, the buffer-region variable doping structure withstands an electric field generated by the semiconductor device, such that the electric field punches through the buffer-region variable doping structure.

2. The buffer-region variable doping structure according to claim 1, comprising a first dopant region A and a second dopant region B, wherein the first dopant region A and the second dopant region B are attached up and down, and when the semiconductor device withstands the breakdown voltage, the first dopant region A and the second dopant region B generate the electric field.

3. The buffer-region variable doping structure according to claim 2, further comprising a second dopant region C and a second dopant region D, wherein the second dopant region C is connected to the second dopant region D, the second dopant region C and the second dopant region D are in a same layer and are both attached to the second dopant region B up and down, and a total dopant dose of the second dopant region D is smaller than a total dopant dose of the second dopant region C, when the second dopant region C and the second dopant region D withstand the electric field, such that the electric field punches through the second dopant region D.

4. The buffer-region variable doping structure according to claim 2, further comprising a second dopant region C, a second dopant region D, and a first dopant region E, wherein the second dopant region C and the first dopant region E are connected to the second dopant region D, the second dopant region C and the second dopant region D are attached to the second dopant region B up and down, the first dopant region E and the second dopant region C are attached up and down, and a total dopant dose of the second dopant region D is smaller than a total dopant dose of the second dopant region C, when the second dopant region C and the second dopant region D withstand the electric field, such that the electric field punches through the second dopant region D.

5. The buffer-region variable doping structure according to claim 2, further comprising a second dopant region C, a second dopant region D, a first dopant region E, and a first dopant region F, wherein the second dopant region C is connected to the second dopant region D, the first dopant region E is connected to the first dopant region F, the second dopant region C and the second dopant region D are attached to the second dopant region B up and down, the first dopant region E and the second dopant region C are attached up and down, the first dopant region F and the second dopant region D are attached up and down, and a total dopant dose of the second dopant region D is smaller than a total dopant dose of the second dopant region C, when the second dopant region C and the second dopant region D withstand the electric field, such that the electric field punches through the second dopant region D.

6. The buffer-region variable doping structure according to any one of claims 3 to 5, wherein the total dopant dose of the second dopant region D is obtained according to the following formula:

$$Q_1 = \frac{\varepsilon_{Si} \times E_1}{q}$$

wherein $Q_1$ is a net total quantity of the dopant per unit area of the second dopant region D, $\varepsilon_{Si}$ is a dielectric coefficient of a base material, $E_1$ is an electric field strength at an interface between the second dopant region D and the second dopant region B under the designed breakdown voltage, and q is a unit charge.

7. The buffer-region variable doping structure according to claim 5, wherein a net total quantity of the dopant per unit area of the first dopant region F is smaller than each of the net total quantities of the dopants per unit area of the other dopant regions.

8. The buffer-region variable doping structure according to claim 5, wherein the net total quantity of the dopant per unit area of the first dopant region F makes the buffer-region variable doping structure under static blocking have a hole emission efficiency equal to or lower than that of another dopant region.

9. A semiconductor device, comprising the buffer-region variable doping structure according to any one of claims 1 to 8, wherein when the semiconductor device withstands a breakdown voltage, the buffer-region variable doping structure withstands an electric field generated by the semiconductor device, such that the electric field punches through the buffer-region variable doping structure.

10. The semiconductor device according to claim 9, wherein the semiconductor device is one of IGCT, GTO, SGTO, IGBT, IEGT, MCT, and ETO.

FIG. 1

Gate

p+Base region

p Base region

$J_2$

n Drift region

n+buffer layer

$J_1$

p+Emitter

Anode

FIG.2

Cathode

R=0

R=7.1mm

1. AG    2. AG    3. AG

4. AG   5. AG

MET

n+          n+          n+

n+        n+

p+

p+          p+

n+

p+

L

R

n⁻

p+

Anode

Metallization

FIG. 3

A           B

## First dopant region A

## Second dopant region B

Second dopant region C | Second dopant region D

FIG. 4

A

B

Electric field
strength

First dopant region A

Second dopant region B

Second dopant region C

Position
coordinates

Electric field
strength

First dopant region A

Second dopant region B

Second dopant region D

Position
coordinates

FIG. 5

| First dopant region A | |
|---|---|
| Second dopant region B | |
| Second dopant region C | Second dopant region D |
| First dopant region E | First dopant region F |

FIG. 6

First dopant region A

Second dopant region B

| Second dopant region C | Second dopant region D |
| First dopant region E | |

FIG. 7

Gate    Cathode    Gate
  A

J3    n+Emitter
p+Base region
p Base region
J2
n-Base region

n Buffer region    HSQ
J1
p+Emitter

Anode

FIG. 8

A

Electric field
strength

p+ base region p base
region

$J_2$

n-Base
region

n Buffer region

$J_1$

Position
coordinates

B

Electric field
strength

p+ base region p base
region

$J_2$

n-Base
region

HSQ

$J_1$

Position
coordinates

FIG. 9

FIG. 10

Sliver    Gate contact    HSQ    Diode structure

1 2 3 4 5

Cathode
ring

FIG. 11

FIG. 12

A

Electric field strength

P Base region

$J_2$

n-Base region

n Buffer region

$J_1$

Position coordinates

B

Electric field strength

p Base region

$J_2$

n-Base region

HSQ

$J_1$

Position coordinates

FIG. 13

Gate    Emitter    A    B

Gate oxide
layer

J4
p+
n    n+Emitter    J3
p Base region    J2

n-Base
region

n Buffer region    HSQ

p+Emitter    J1

Collector

FIG. 14

FIG. 15

<table>
<tr><td colspan="2" align="center">**INTERNATIONAL SEARCH REPORT**</td><td>International application No.<br>**PCT/CN2020/123817**</td></tr>
</table>

| | |
|---|---|
| **A.** | **CLASSIFICATION OF SUBJECT MATTER** |
| | H01L 29/06(2006.01)i; H01L 29/36(2006.01)i |

According to International Patent Classification (IPC) or to both national classification and IPC

| | |
|---|---|
| **B.** | **FIELDS SEARCHED** |

Minimum documentation searched (classification system followed by classification symbols)
    H01L

Documentation searched other than minimum documentation to the extent that such documents are included in the fields searched

Electronic data base consulted during the international search (name of data base and, where practicable, search terms used)
    SIPOABS, DWPI, CNABS, CNKI, IEEE: 击穿, 掺杂, 浓度, 剂量, 可变, 缓冲, breakdown, doping, concentration, dose, variable, buffer

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | CN 106920844 A (UNIVERSITY OF ELECTRONIC SCIENCE AND TECHNOLOGY OF CHINA) 04 July 2017 (2017-07-04)<br>    description paragraphs [0007]-[0018], [0034], [0036], figures 4-9 | 1-5, 9, 10 |
| A | CN 106298898 A (SEMICONDUCTOR MANUFACTURING INTERNATIONAL (SHANGHAI) CORPORATION) 04 January 2017 (2017-01-04)<br>    entire document | 1-10 |
| A | CN 101916730 A (SHANGHAI INSTITUTE OF MICROSYSTEM AND INFORMATION TECHNOLOGY, CHINESE ACADEMY OF SCIENCES et al.) 15 December 2010 (2010-12-15)<br>    entire document | 1-10 |
| A | CN 103594504 A (XI'AN YONGDIAN ELECTRIC CO., LTD.) 19 February 2014 (2014-02-19)<br>    entire document | 1-10 |
| A | JP S574169 A (SHIBAURA ELECTRONICS CO., LTD.) 09 January 1982 (1982-01-09)<br>    entire document | 1-10 |

| | |
|---|---|
| ☐ Further documents are listed in the continuation of Box C. | ☑ See patent family annex. |

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 January 2021** | **21 January 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

## INTERNATIONAL SEARCH REPORT
### Information on patent family members

| International application No. |
| --- |
| **PCT/CN2020/123817** |

| Patent document cited in search report | | | Publication date (day/month/year) | Patent family member(s) | | | Publication date (day/month/year) |
| --- | --- | --- | --- | --- | --- | --- | --- |
| CN | 106920844 | A | 04 July 2017 | CN | 106920844 | B | 29 November 2019 |
| CN | 106298898 | A | 04 January 2017 | CN | 106298898 | B | 05 November 2019 |
| CN | 101916730 | A | 15 December 2010 | CN | 101916730 | B | 11 July 2012 |
| CN | 103594504 | A | 19 February 2014 | None | | | |
| JP | S574169 | A | 09 January 1982 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010215412
- CN 202020388279